# EUROPEAN PATENT SPECIFICATION

(11) **EP 2 498 513 B1**
(45) Date of publication and mention of the grant of the patent: **06.01.2016**
(21) Application number: 10828422.5
(22) Date of filing: 11.02.2010
(51) Int. Cl.: H04R 19/04

(54) **MEMS MICROPHONE AND METHOD FOR MANUFACTURING SAME**
MEMS-MIKROFON UND HERSTELLUNGSVERFAHREN DAFÜR
MICROPHONE EN TECHNOLOGIE MEMS, ET PROCÉDÉ DE FABRICATION CORRESPONDANT

(30) Priority: 06.11.2009 KR 20090106943
(43) Date of publication of application: 12.09.2012
(73) Proprietor: BSE Co., Ltd., Incheon 405-817 (KR)
(72) Inventor: KIM, Yong-Kook, Seoul 157-040 (KR); SONG, Chung-Dam, Seoul 157-801 (KR)
(74) Representative: Mollekopf, Gerd Willi
(86) International application number: PCT/KR2010/000874
(87) International publication number: WO 2011/055885

(56) References cited:
- WO-A1-2007/117198
- CN-A- 101 572 850
- JP-A- 2002 209 298
- JP-A- 2002 328 117
- JP-A- 2009 100 177
- KR-B1- 100 609 069
- KR-B1- 100 901 777
- US-A1- 2003 021 432
- US-A1- 2004 067 604
- US-A1- 2006 008 098
- US-A1- 2007 284 682
- US-A1- 2007 284 682
- US-A1- 2008 075 308

## Description

### Technical Field

One or more aspects of the present invention relate to micro electro mechanical systems (MEMS) microphones and methods of manufacturing the same.

### Background Art

A microphone is a device for converting a voice into an electrical signal. The microphone may be used in various mobile communication devices such as mobile terminals, and various communication devices such as earphones or hearing aids. The microphone needs to have excellent electronic/audible performance, reliability, and operability.

Examples of the microphone include a condenser microphone and a micro electro mechanical systems (MEMS) microphone.

The condenser microphone is manufactured by respectively manufacturing a diaphragm, a back plate, a signal-processing printed circuit board (PCB), and the like, and then assembling these components in a case. In order to manufacture the condenser microphone, the PCB is separately manufactured. Thus, the manufacturing costs of the condenser microphone are high, and there is a limit in miniaturizing the condenser microphone.

The MEMS microphone is manufactured by forming an acoustic transducer such as a diaphragm, a back plate, and the like on a single silicon substrate by using a semiconductor process.

Korean Patent Application No. 10-2002-0074492 (filed on November 27, 2002) discloses a MEMS microphone. During the manufacture of the MEMS microphone, heat-treatment is performed at a high temperature of about 1100°C in order to inject electrons into a lower electrode. In this case, since a membrane (i.e., a diaphragm) includes a metal lower electrode, a silicon nitride layer, and a silicon oxide layer which are formed of substantially different materials, a residual stress (a compression stress, or an expansion stress) may be generated due to a difference in thermal expansion coefficients between the different materials during the heat-treatment at a high temperature. As the residual stress acts on the membrane, the membrane may be deformed or may crack. Furthermore, since the residual stress acts on the membrane, it may be difficult for the membrane to correctly vibrate according to a sound, and thus, it may be difficult to correctly convert a sound into an electrical signal.

International Publication No. WO 2007/112743 (published on March 29, 2007) discloses a method of manufacturing a MEMS microphone with a back volume formed by oxidizing a silicon substrate. In this case, in order to form the back volume on the silicon substrate, deposition and etching processes (operations 1a through 1h) are sequentially performed on a conductive layer, a metal layer, a silicon oxide layer, and the like so as to form a porous silicon structure, and the porous silicon structure is oxidized. However, since a plurality of processes are required to form the porous silicon structure, the time for manufacturing the MEME microphone may be remarkably increased. In addition, since an oxidizing speed of silicon of the porous silicon structure may be changed according to a voltage condition, the back volume may not be uniformly etched. When a surface of the back volume is not be uniformly etched, a distance between the diaphragm and the back plate is not constant, and thus, it may be difficult to correctly convert a sound into an electrical signal.

In addition, the diaphragm and the back plate of the MEMS microphone are formed of polysilicon. Since the diaphragm and the back plate need to be connected to a circuit for measuring a capacitance, the diaphragm and the back plate need to be conductive. Thus, ions are injected into the diaphragm and the back plate, and then the diaphragm and the back plate are heated at a high temperature of about 1100°C in order to stabilize the resultant.

In this case, since the manufacturing method includes manufacturing an application specific integrated (ASIC) chip including a circuit formed by patterning a metallic material and then manufacturing a MEMS chip, it is difficult to manufacture the MEMS chip and the ASIC chip as a single chip. This is because when the ASIC chip is exposed to a high temperature during manufacture of the MEMS ship, the ASIC chip may be melted or damaged. Furthermore, since it is difficult to form the MEMS chip and the AISIC chip as a single chip, the MEMS chip and the ASIC chip may be separately manufactured, thereby increasing the number of manufacturing processes and manufacturing costs.

The MEMS microphones disclosed in the two above-described cited references have a structure formed by stacking a membrane and a back plate on a silicon substrate, thereby having increased heights. Accordingly, there is a limit in manufacturing a miniaturized microphone.

WO 2007/117198 A1 is directed to a microelectromechanical (MEMS) pressure sensor and microphone. A passivation layer is deposited on a silicon substrate. An electrode (back plate) is formed in a recess of the passivation layer. A membrane is arranged above the electrode, such that an air gap or cavity is provided between them. The electrode, cavity and membrane sense a pressure applied to the membrane according to a capacitive sensing principle.

### Disclosure of the Invention

The invention is defined in claims 1, 8 and 9, respectively. Particular embodiments are set out in the dependent claims.

According to an aspect of the present invention, there is provided a micro electro mechanical systems (MEMS) microphone including a silicon substrate in which a back chamber is formed by etching a lower portion of the silicon substrate and on which an air-gap forming portion is formed above the chamber by etching an upper portion of the silicon substrate to a predetermined depth above the chamber; a membrane formed on the air-gap forming portion of the silicon substrate or the silicon substrate; and a back plate that is formed on the air-gap forming portion or the silicon substrate so as to be spaced apart from the membrane, wherein an air gap is formed between the membrane and the back plate.

According to another aspect of the present invention, there is provided a method of manufacturing a MEMS microphone, the method including etching an air-gap forming portion to a predetermined depth on a silicon substrate; forming a membrane on the air-gap forming portion of the silicon substrate; forming a sacrificial layer on the membrane; forming a back plate on the sacrificial layer so that a plurality of sound holes are formed in the back plate; forming a back chamber by etching a lower portion of the silicon substrate; and forming an air gap between the membrane and the back plate by removing the sacrificial layer.

According to another aspect of the present invention, there is provided a method of manufacturing a MEMS microphone, the method including etching an air-gap forming portion to a predetermined depth on a silicon substrate; forming a back plate on the air-gap forming layer of the silicon substrate so that a plurality of sound holes are formed in the back plate; forming a sacrificial layer on the back plate; forming a membrane on the sacrificial layer; forming a back chamber by etching a lower portion of the silicon substrate; and forming an air gap between the membrane and the back plate by removing the sacrificial layer.

### Advantageous Effects

According to one or more embodiments of the present invention, since a membrane and a back plate are formed by electroless plating, it is not required to perform a separate high temperature heating process in order to inject metallic ions into polysilicon, thereby reducing the number of manufacturing processes of a micro electro mechanical systems (MEMS) microphone.

Since the membrane and the back plate are formed at a low temperature (about 90°C) by electroless plating, a MEMS chip and an application specific integrated (ASIC) chip may be formed as a single chip. In addition, the MEMS microphone may be manufactured by using a unified semiconductor manufacturing method.

Since the MEMS microphone is manufactured at a low temperature, even though thermal expansion coefficients of the membrane and the back plate are different, a residual stress generated in the membrane and the back plate may be reduced. In addition, a contact region between the silicon substrate and the membrane and the back plate may be prevented from cracking.

Since the membrane and the back plate are formed by electroless plating, the thicknesses of the membrane and the back plate may be easily adjusted, thereby stabilizing acoustic features and increasing acoustic sensitivity.

Since an air gap is formed by etching the silicon substrate followed by forming the membrane and the back plate, the air gap may be correctly and simply formed. Furthermore, the height of the MEMS microphone may be reduced, and the membrane and the back plate may be stably fixed to the silicon substrate.

Since a sacrificial layer is formed on an air-gap forming portion of the silicon substrate, it is not required to form or etch a separate layer in order to form the sacrificial layer, thereby reducing the number of manufacturing processes.

In addition, since the membrane and the back plate are formed of a flexible material, the membrane and the back plate may be prevented from being damaged or deformed when external shocks act on the membrane and the back plate.

### Brief Description of the Drawings

FIGS. 1 through 3 are cross-sectional views for explaining a process of forming an air-gap forming portion on a silicon substrate in a micro electro mechanical systems (MEMS) microphone according to an embodiment of the present invention;
FIGS. 4 through 6 are cross-sectional views for explaining a process of forming a membrane on the air-gap forming portion of the silicon substrate of FIG. 3, according to an embodiment of the present invention;
FIGS. 7 and 8 are cross-sectional views for explaining a process of forming a back plate and a sacrificial layer 33 on a membrane of the silicon substrate of FIG. 6, according to an embodiment of the present invention;
FIGS. 9 through 11 are cross-sectional views for explaining a process of forming a back chamber and an air gap in the silicon substrate of FIG. 8, according to an embodiment of the present invention;
FIG. 12 is a top view of a MEMS microphone of FIG. 11 according to an embodiment of the present invention;
FIG. 13 is a cross-sectional view for explaining a process of forming an air-gap forming portion on a silicon substrate in a MEMS microphone according to another embodiment of the present invention;
FIGS. 14 through 16 are cross-sectional views for explaining a process of forming a back plate on an air-gap forming portion of the silicon substrate of FIG. 13, according to another embodiment of the present invention;
FIGS. 17 and 18 are cross-sectional views for explaining a process of forming a sacrificial layer and a membrane on the silicon substrate of FIG. 16, according to another embodiment of the present invention.
FIGS. 19 and 20 are cross-sectional views for explaining a process of forming a back chamber and an air gap in the silicon substrate of FIG. 18, according to another embodiment of the present invention;
FIG. 21 is a top view of a MEMS microphone of FIG. 20 according to another embodiment of the present invention;
FIGS. 22 and 23 are cross-sectional views for explaining a process of forming an air-gap forming portion on a silicon substrate in a MEMS microphone according to another embodiment of the present invention;
FIGS. 24 through 26 are cross-sectional views for explaining a process of forming a membrane on an air-gap forming portion of the silicon substrate of FIG. 23, according to another embodiment of the present invention;
FIGS. 27 and 28 are cross-sectional views for explaining a process of forming a sacrificial layer and a back plate on a membrane of the silicon substrate of FIG. 26, according to another embodiment of the present invention;
FIGS. 29 and 30 are cross-sectional views for explaining a process of forming a back chamber and an air gap in the silicon substrate of FIG. 28, according to another embodiment of the present invention;
FIG. 31 is a cross-sectional view for explaining a process of forming an air-gap forming portion on a silicon substrate of a MEMS microphone according to another embodiment of the present invention;
FIGS. 32 through 34 are cross-sectional views for explaining a process of forming a back plate on an air-gap forming portion of the silicon substrate of FIG. 31, according to another embodiment of the present invention;
FIGS. 35 and 36 are cross-sectional views for explaining a process of forming a sacrificial layer and a membrane on the silicon substrate of FIG. 34, according to another embodiment of the present invention and
FIGS. 37 and 38 are cross-sectional views for explaining a process of forming a back chamber and an air gap in the silicon substrate of FIG. 36, according to another embodiment of the present invention.

### Best mode for carrying out the Invention

Hereinafter, a micro electro mechanical systems (MEMS) microphone will be described with regard to exemplary embodiments of the invention with reference to the attached drawings.

A MEMS microphone according to an embodiment of the present invention will be described below.

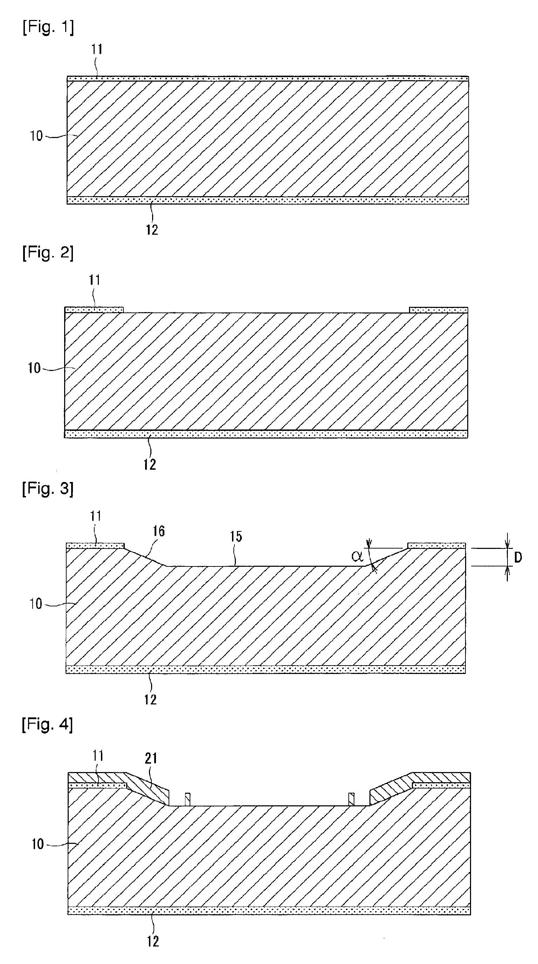

FIGS. 1 through 3 are cross-sectional views for explaining a process of forming an air-gap forming portion 15 on a silicon substrate 10 in a MEMS microphone according to an embodiment of the present invention.

Referring to FIGS. 1 and 2, the MEMS microphone according to the present embodiment includes the silicon substrate 10. Insulating protective layers 11 and 12 are formed by depositing silicon nitride (Si₃N₄) or silicon oxide (SiO₂) on two sides of the silicon substrate 10, respectively (refer to FIG. 1 and FIG. 2). In this case, the insulating protective layers 11 and 12 are formed by depositing Si₃N₄ on a surface of the silicon substrate 10 by using a low pressure chemical vapor deposition (LPCVD) method.

The insulating protective layer 11 formed on an upper surface of the silicon substrate 10 is etched in order to form the air-gap forming portion 15 (refer to FIG. 2). In this case, the insulating protective layer 11 formed on the upper surface of the silicon substrate 10 may be etched by using reactive ion etching (RIE) equipment.

Referring to FIG. 3, the air-gap forming portion 15 is formed to have a predetermined depth by wet-etching an upper portion of the silicon substrate 10 by using a KOH solution or a tetramethylammonium hydroxide (TMAH) solution.

A mask material (not shown) of the air-gap forming portion 15 may be Si₃N₄, SiO₂, or the like.

By adjusting a depth D of the air-gap forming portion 15 to a predetermined depth, an interval between a membrane 25 and a back plate 37 which will be described below may be adjusted. The depth D of the air-gap forming portion 15 may be adjusted according to the concentration, etching time, and temperature of the KOH solution or the TMAH solution. The concentration, etching time, and temperature of the KOH solution or the TMAH solution may be appropriately adjusted according to the depth D of the air-gap forming portion 15.

In addition, an inclination surface 16 having an inclination angle (α) of about 54.74° may be formed on a circumference of the air-gap forming portion 15 by wet-etching the circumference of the air-gap forming portion 15 by using the KOH solution or the TMAH solution. In this case, a reaction between silicon and the KOH solution or the TMAH solution occurs at a relatively low speed in an inclination direction (a 111 surface direction) of a silicon crystal, and a reaction between silicon and the KOH solution or the TMAH solution occurs at a relatively high speed in a vertical direction (a 100 surface direction) of a silicon crystal. Thus, the circumference of the air-gap forming portion 15 may be etched to have the inclination surface 16.

FIGS. 4 through 6 are cross-sectional views for explaining a process of forming the membrane 25 on the air-gap forming portion 15 of the silicon substrate 10 of FIG. 3, according to an embodiment of the present invention.

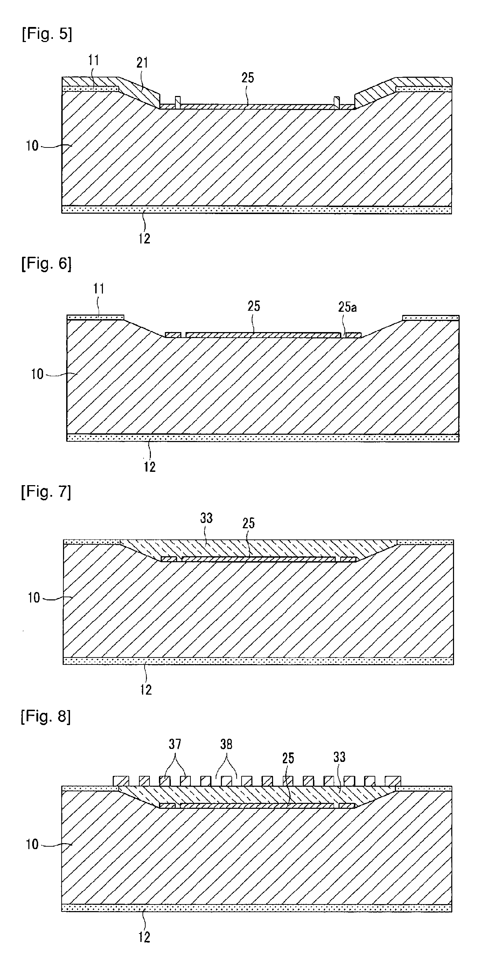

Referring to FIGS. 4 through 6, the membrane 25 is formed on the air-gap forming portion 15 of the silicon substrate 10. In this case, an air through hole 25a is formed in the membrane 25 so that air may pass through the air through hole 25a (refer to FIG. 6). The membrane 25 is a diaphragm that vibrates according to a sound pressure, and constitutes a lower electrode of a condenser for measuring a capacitance.

The membrane 25 may be formed by electroless plating. In this case, electroless plating is a method of precipitating metal on a surface of a silicon substrate by reducing metal ions by using an action of a reducing agent without using electrical energy applied from an external source. By using the electroless plating, the membrane 25 may have a uniform thickness, and the membrane 25 may also be easily formed on a bent surface, compared to a case where electro plating is used.

The electroless plating of the membrane 25 is performed as follows. First, a photosensitive mask material 21 is coated on a surface of the silicon substrate 10 on which the air-gap forming portion 15 is formed. A region of a surface of the silicon substrate 10, in which the membrane 25 is to be formed, is patterned by exposing and developing the photosensitive mask material 21 (refer to FIG. 4). The region of the surface of the silicon substrate 10 is activated for nickel electroless plating. The membrane 25 formed of nickel is formed on the activated region of the silicon surface of the silicon substrate 10 by electroless plating (refer to FIG. 5). After forming the membrane 25 of nickel, the photosensitive mask material 21 is removed (refer to FIG. 6). Lastly, a surface of the membrane 25 is washed.

In addition, since the membrane 25 is formed by electroless plating in which conductive ions are reduced and substituted at a low temperature of about 90°C, it is not required to heat the membrane 25 at a high temperature of about 1100°C in order to form the membrane 25, unlike in a conventional method. Since the membrane 25 is formed of a metallic material, the membrane 25 may be electrically connected to an external circuit (e.g., an ASIC chip) for measuring a capacitance. Thus, since it is not required to inject conductive ions into a membrane layer formed of polysilicon, it is not required to perform a separate high temperature heating process in order to inject metallic ions into polysilicon, thereby reducing the number of manufacturing processes.

Even though thermal expansion coefficients of the membrane 25 and the silicon substrate 10 are different, since the membrane 25 and the silicon substrate 10 are not heated at a high temperature, a residual stress such as a compressive stress or a tensile stress is barely generated in a contact region between the membrane 25 and the silicon substrate 10. Thus, since the membrane 25 is barely deformed due to a residual stress, the membrane 25 may vibrate normally, thereby stabilizing an acoustic feature. In addition, a residual stress is barely generated between the membrane 25 and the silicon substrate 10, thereby preventing the contact region between the membrane 25 and the silicon substrate 10 from cracking.

On the other hand, if the membrane 25 is formed by electro plating, it is required to form a seed layer on the silicon substrate 10 and then to supply a current through the seed layer. In this case, the current is partially distributed to have an ununiform current density in the seed layer, rather than being distributed to have a uniform current density. Thus, since conductive ions are plated on the membrane 25 to have an ununiform thickness, the thickness of the membrane 25 is not uniform overall. However, according to the present embodiment, since electroless plating is used, a current is distributed in the membrane 25 to have a uniform current density, and thus the thickness of the membrane 25 is uniform overall.

The membrane 25 may be formed of a flexible conductive material including nickel. Since the membrane 25 is formed of a conductive material, a current may flow through the membrane 25. In addition, since the membrane 25 is formed of a flexible material, the membrane 25 may be prevented from being damaged when the membrane 25 vibrates due to an overvoltage or an external vibration.

The membrane 25 may be formed to have a thickness from about 0.1 to about 5 *µ*m. The thickness of the membrane 25 may be appropriately adjusted according to a sound pressure detected by the MEMS microphone according to the present embodiment.

If the membrane 25 is formed by electro plating, since plating metal vapor is sprayed in a vertical direction or at a slight inclination angle from an upper portion towards a lower portion of the air-gap forming portion 15 by a sputter or an E-beam, the membrane 25 and an electrode thereof (not shown) are likely to short circuit on the inclination surface 16 of the air-gap forming portion 15. However, according to the present embodiment, when the membrane 25 is formed by electroless plating, since the membrane 25 may also be easily formed on a bent surface, the membrane 25 and the electrode thereof (not shown) may not short circuit and may be easily connected to each other.

FIGS. 7 and 8 are cross-sectional views for explaining a process of forming the back plate 37 and a sacrificial layer 33 on the membrane 25 of the silicon substrate 10 of FIG. 6, according to an embodiment of the present invention.

Referring to FIG. 7, the sacrificial layer 33 is formed on the air-gap forming portion 15. In this case, the sacrificial layer 33 is formed on an air-gap forming portion formed by etching the silicon substrate 10 to have a predetermined depth, it is not required to form or etch a separate layer in order to form the sacrificial layer 33. Thus, the sacrificial layer 33 may be easily formed, and the number of manufacturing processes may be reduced.

The sacrificial layer 33 may be formed so that an upper surface of the sacrificial layer 33 may have the same layer level as an upper surface of the silicon substrate 10. In this case, if the sacrificial layer 33 is formed of a material having a relatively high viscosity, a surface of the sacrificial layer 33 may be planarized by chemical mechanical polishing (CMP). If the sacrificial layer 33 is formed of a material having a relatively low viscosity, the sacrificial layer 33 may be formed to have a planarized surface, and thus, separate CMP may not be performed.

The sacrificial layer 33 may be formed of silicon oxide, photoresist, plating copper, or the like.

Referring to FIG. 8, the back plate 37 may be formed on the sacrificial layer 33 by electroless plating. The back plate 37 may be formed to have a thickness of about 2 to about 100 *µ*m. The back plate 37 is an upper electrode of a condenser, which faces the membrane 25 and measures a capacitance.

Electroless plating of the back plate 37 is performed as follows. First, a photosensitive mask material (not shown) is coated on a surface of the sacrificial layer 33. A region of the photosensitive mask material, in which the back plate 37 is to be formed, is patterned by exposing and developing the photosensitive mask material. In this case, the region of the photosensitive mask material, in which the back plate 37 is to be formed, has a predetermined shape so as to have a plurality of sound holes 38. A surface of the back plate 37 is activated for nickel electroless plating. The back plate 37 is formed on the surface of the back plate 37 by electroless plating. The back plate 37 is formed by forming the back plate 37 and then removing the photosensitive mask material. Lastly, the surface of the back plate 37 is washed. The electroless plating of the back plate 37 is substantially the same as the electroless plating of the membrane 25.

Since the back plate 37 is formed by electroless plating in which conductive ions are reduced and substituted at a low temperature of about 90°C, it is not required to heat the back plate 37 at a high temperature of about 1100°C in order to form the back plate 37, unlike in a conventional method. Since the back plate 37 is formed of a metallic material, the back plate 37 may be electrically connected to an external circuit (e.g., an ASIC chip) for measuring a capacitance. Thus, since it is not required to inject conductive ions into a back plate layer, a separate high temperature heating process is not performed in order to inject metallic ions into polysilicon, thereby reducing the number of manufacturing processes.

Even though thermal expansion coefficients of the back plate 37 and the silicon substrate 10 are different, since the back plate 37 and the silicon substrate 10 are not heated at a high temperature, a residual stress such as a compressive stress or a tensile stress is barely generated in a contact region between the back plate 37 and the silicon substrate 10. Thus, the back plate 37 is barely deformed due to a residual stress, thereby stabilizing an acoustic feature. In addition, a residual stress is barely generated between the back plate 37 and the silicon substrate 10, thereby preventing the contact region between the back plate 37 and the silicon substrate 10 from cracking.

On the other hand, if the back plate 37 is formed by electro plating, it is required to form a seed layer on the silicon substrate 10 and then to supply a current through the seed layer. In this case, the current is partially distributed to have a non-uniform current density in the seed layer, rather than being distributed to have a uniform current density. Thus, since conductive ions are plated on the back plate 37 to have a non-uniform thickness, the thickness of the back plate 37 may not be uniform overall.

The back plate 37 may be formed of a flexible conductive material including nickel. Since the back plate 37 is formed of a conductive material, a current may flow through the back plate 37. In addition, since the back plate 37 is formed of a flexible material, the back plate 37 may be prevented from being damaged when external shocks act on the back plate 37.

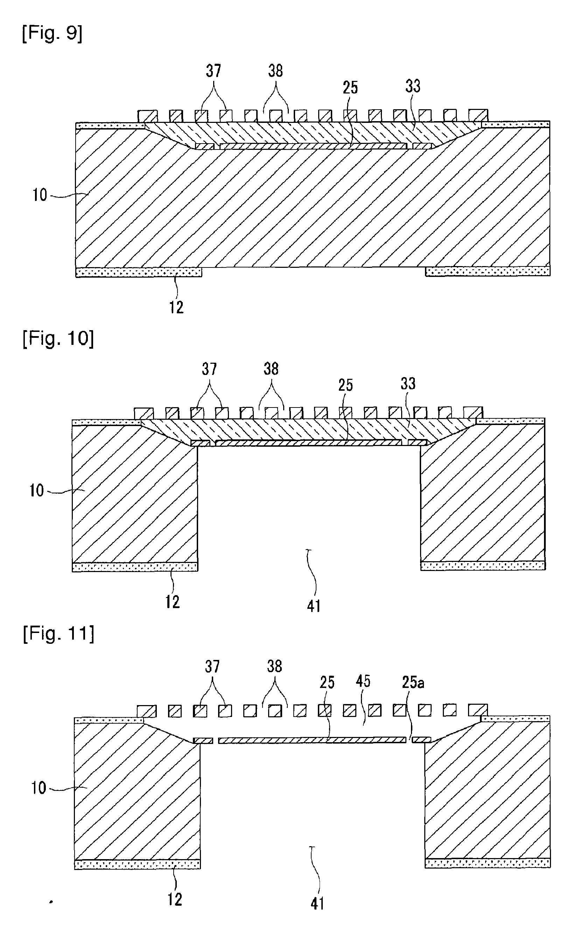

FIGS. 9 through 11 are cross-sectional views for explaining a process of forming a back chamber 41 and an air gap 45 in the silicon substrate 10 of FIG. 8, according to an embodiment of the present invention.

Referring to FIGS. 9 and 10, a photosensitive mask material (not shown) is coated on the lower insulating protective layer 12 of the silicon substrate 10. A region of the photosensitive mask material, in which the back chamber 41 is to be formed, is patterned by exposing and developing the photosensitive mask material (refer to FIG. 9).

The region in which the back chamber 41 is to be formed may be wet-anisotropic etched by a KOH solution or a TMAH solution (refer to FIG. 10). In this case, the mask material may be silicon nitride, silicon dioxide, a photosensitive material, gold, or chrome.

The region in which the back chamber 41 is to be formed may be dry-anisotropic etched by deep reactive ion etching (DRIE). In this case, a mask material may be silicon nitride, silicon dioxide, gold, or chrome.

The back chamber 41 is formed below the membrane 25 by etching a lower portion of the silicon substrate 10.

Referring to FIG. 11, the sacrificial layer 33 is removed by etching the sacrificial layer 33 through the sound holes 38 of the back plate 37. In this case, the air gap 45 is formed between the membrane 25 and the back plate 37 by removing the sacrificial layer 33. Due to the air gap 45, when a sound pressure acts on the membrane 25, the membrane 25 may not contact the back plate 37 while vibrating.

A height of the air gap 45 may be previously determined according to an etching depth of the air-gap forming portion 15 and a depositing height of the sacrificial layer 33. Thus, the membrane 25 and the back plate 37 may be formed in the silicon substrate 10 or a surface of the silicon substrate 10 rather than being formed above the silicon substrate 10. Thus, the height of the MEMS microphone according to the present embodiment may be reduced by as much as the height of the back plate 37 and membrane 25, as compared to a conventional MEMS microphone.

Due to the air through hole 25a of the membrane 25, since air may pass through the air gap 45 and the back chamber 41 when a sound pressure acts on the membrane 25, a pressure that is almost the same as an atmospheric pressure may be formed in the back chamber 41. Thus, a sound pressure may normally act on the membrane 25.

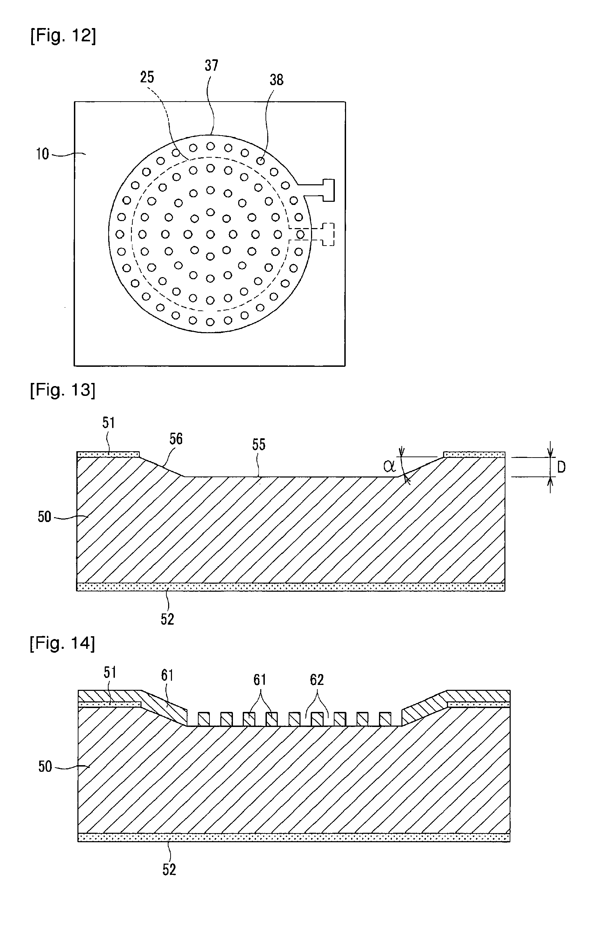

FIG. 12 is a top view of the MEMS microphone of FIG. 11 according to an embodiment of the present invention.

Referring to FIG. 12, the air-gap forming portion 15 is formed to have a circular shape on a surface of the silicon substrate 10. The membrane 25 and the back plate 37 may also be formed to have a circular shape on the silicon substrate 10. Of course, the air-gap forming portion 15, the membrane 25, and the back plate 37 may be formed to have a polygonal shape.

The sound holes 38 may be formed in the back plate 37 so that air may pass through the sound holes 38.

Terminals are formed on the membrane 25 and the back plate 37, and thus, the membrane 25 and the back plate 37 may be connected to an external device such as an ASIC chip.

In the MEMS microphone manufactured as described above, when the membrane 25 vibrates according to a sound pressure, the height of the air gap 45 formed between the membrane 25 and the back plate 37 is changed. In this case, as the height of the air gap 45 is changed, a capacitance is changed, and a voice is converted into an electrical signal according to the changed capacitance.

A MEMS microphone according to another embodiment of the present invention will be described below.

FIG. 13 is a cross-sectional view for explaining a process of forming an air-gap forming portion 55 on a silicon substrate 50 in a MEMS microphone according to another embodiment of the present invention.

Referring to FIG. 13, the MEMS microphone according to the present embodiment includes the silicon substrate 50. Insulating protective layers 51 and 52 are formed by depositing silicon nitride (Si₃N₄) or silicon oxide (SiO₂) on two sides of the silicon substrate 50, respectively. In this case, the insulating protective layers 51 and 52 are formed by depositing Si₃N₄ on a surface of the silicon substrate 50 by using a LPCVD method.

The insulating protective layer 51 formed on an upper surface of the silicon substrate 50 is etched in order to form the air-gap forming portion 55. In this case, the insulating protective layer 51 formed on the upper surface of the silicon substrate 50 may be etched by using RIE equipment.

The air-gap forming portion 55 is formed to have a depth D by etching an upper portion of the silicon substrate 50 by using a KOH solution or a TMAH solution. A mask material 61 of the air-gap forming portion 55 may be Si₃N₄, SiO₂, or the like.

By adjusting the depth D of the air-gap forming portion 55 to a predetermined depth, an interval between a membrane 77 and a back plate 65 which will be described below may be adjusted. The depth D of the air-gap forming portion 55 may be adjusted according to the concentration, etching time and temperature of the KOH solution or the TMAH solution.

In addition, an inclination surface 56 having an inclination angle (α) of about 54.74° may be formed on a circumference of the air-gap forming portion 55 by etching the circumference of the air-gap forming portion 55 by using the KOH solution or the TMAH solution. In this case, a reaction between silicon and the KOH solution or the TMAH solution occurs at a relatively low speed in an inclination direction (a 111 surface direction) of a silicon crystal, and a reaction between silicon and the KOH solution or the TMAH solution occurs at a relatively high speed in a vertical direction (a 100 surface direction) of a silicon crystal. Thus, the circumference of the air-gap forming portion 55 may be etched to have the inclination surface 56.

FIGS. 14 through 16 are cross-sectional views for explaining a process of forming the back plate 65 on the air-gap forming portion 55 of the silicon substrate 50 of FIG. 13, according to another embodiment of the present invention.

Referring to FIGS. 14 through 16, the back plate 65 is formed on the air-gap forming portion 55 of the silicon substrate 50. The back plate 65 may be formed by electroless plating. The back plate 65 may be a lower electrode of a condenser for measuring vibration by using a capacitance.

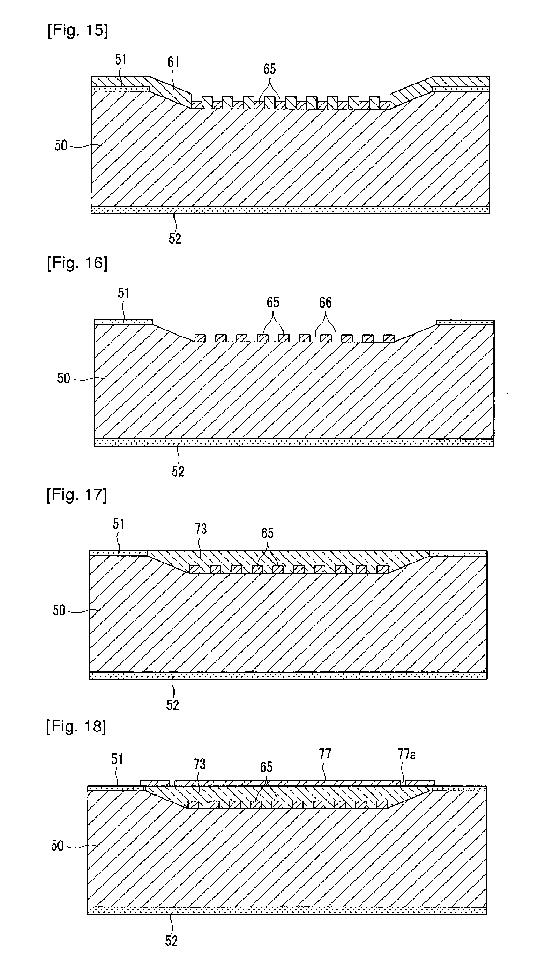

Electroless plating of the back plate 65 is performed as follows. First, a photosensitive mask material 61 is coated on a surface of the silicon substrate 50 on which the air-gap forming portion 55 is formed. A region of a surface of the silicon substrate 50, in which the back plate 65 and a plurality of sound holes 66 are to be formed, is patterned by exposing and developing the photosensitive mask material 61 (refer to FIG. 14 The region of the silicon surface of the silicon substrate 50 is activated for nickel electroless plating. The back plate 65 formed of nickel is formed on the activated region of the silicon surface of the silicon substrate 50 by electroless plating (refer to FIG. 15) .After the back plate 65 formed of nickel is formed, the photosensitive mask material 61 is removed (refer to FIG. 16). Lastly, a surface of the back plate 65 is washed.

Since the back plate 65 is formed by electroless plating in which conductive ions are reduced and substituted at a low temperature of about 90°C, it is not required to heat the back plate 65 at a high temperature of about 1100°C in order to form the back plate 65, unlike in a conventional method. In addition, the back plate 65 is formed of a metallic material, the back plate 65 may be electrically connected to an external circuit (e.g., an ASIC chip) for measuring a capacitance. Thus, it is not required to perform a separate high temperature heating process in order to inject metallic ions into polysilicon and stabilize the resultant, thereby reducing the number of manufacturing processes.

Even though thermal expansion coefficients of the back plate 65 and the silicon substrate 50 are different, since the back plate 65 and the silicon substrate 50 are not heated at a high temperature, a residual stress such as a compressive stress or a tensile stress is barely generated in a contact region between the back plate 65 and the silicon substrate 50. Thus, the back plate 65 is barely deformed due to a residual stress, thereby preventing the contact region between the back plate 65 and the silicon substrate 50 from cracking.

On the other hand, if the back plate 65 is formed by electro plating, it is required to form a seed layer on the silicon substrate 50 and then to supply a current through the seed layer. In this case, the current is partially distributed to have an ununiform current density in the seed layer, rather than being distributed to have a uniform current density. Thus, since conductive ions are plated on the back plate 65 to have an ununiform thickness, the thickness of the back plate 65 is not uniform overall. However, according to the present embodiment, since electroless plating is used, a current is distributed in the back plate 65 to have a uniform current density, and thus, the thickness of the back plate 65 is uniform overall.

The back plate 65 may be formed of a flexible conductive material including nickel. Since the back plate 65 is formed of a conductive material, a current may flow through the back plate 65. In addition, since the back plate 65 is formed of a flexible material, the back plate 65 may be prevented from being damaged due to external shocks.

The back plate 65 may be formed to have a thickness of about 2 to about 10 *µ*m. The thickness of the back plate 65 may be appropriately adjusted according to a sound pressure detected by the MEMS microphone according to the present embodiment.

If the back plate 65 is formed by electro plating, since plating metal vapor is sprayed in a vertical direction or at a slight inclination angle from an upper portion towards a lower portion of the air-gap forming portion 55 by a sputter or an E-beam, the back plate 65 and an electrode thereof (not shown) are likely to short circuit on the inclination surface 56 of the air-gap forming portion 55. However, according to the present embodiment, when the back plate 65 is formed by electroless plating, since the back plate 65 may also be easily formed on a bent surface, the back plate 65 and the electrode thereof (not shown) may not short circuit and may be easily connected to each other.

FIGS. 17 and 18 are cross-sectional views for explaining a process of forming a sacrificial layer 73 and the membrane 77 on the silicon substrate 50 of FIG. 16, according to another embodiment of the present invention.

Referring to FIG. 17, the sacrificial layer 73 is formed on the air-gap forming portion 55. In this case, since the sacrificial layer 73 is formed on the air-gap forming portion 55 formed by etching the silicon substrate 50 to have the depth D, it is not required to form or etch a separate layer in order to form the sacrificial layer 73. Thus, the sacrificial layer 73 may be easily formed, and the number of manufacturing processes may be reduced.

The sacrificial layer 73 may be formed so that an upper surface of the sacrificial layer 73 may have the same layer level as an upper surface of the silicon substrate 50. In this case, if the sacrificial layer 73 is formed of a material having a relatively high viscosity, a surface of the sacrificial layer 73 may be planarized by CMP. If the sacrificial layer 73 is formed of a material having a relatively low viscosity, the sacrificial layer 73 may be formed to have a planarized surface, and thus, separate CMP may not be performed.

The sacrificial layer 73 may be formed of silicon oxide, photoresist, plating copper, or the like.

Referring to FIG. 18, the membrane 77 may be formed on the sacrificial layer 73 by electroless plating. An air through hole 77a is formed in the membrane 77. The membrane 77 may be formed to have a thickness of about 0.1 to about 5 *µ*m. The membrane 77 is a diaphragm that faces the back plate 65 and vibrates according to a sound pressure, and constitutes together with the back plate 65 an upper electrode of a condenser for measuring a capacitance.

The electroless plating of the membrane 77 is performed as follows. First, a photosensitive mask material (not shown) is coated on a surface of the sacrificial layer 73. A region of the sacrificial layer 73, in which the membrane 77 is to be formed, is patterned by exposing and developing the photosensitive mask material. The region of a surface of the sacrificial layer 73 is activated for nickel electroless plating. The membrane 77 formed of nickel is formed on the surface of the membrane 77 by electroless plating. After the membrane 77 formed of nickel is formed, the photosensitive material is removed. Lastly, a surface of the membrane 77 is washed.

Since the membrane 77 is formed by electroless plating in which conductive ions are reduced and substituted at a low temperature of about 90°C, it is not required to heat the membrane 77 at a high temperature of about 1100°C in order to form the membrane 77, unlike in a conventional method.

Since the membrane 77 is formed of a metallic material, the membrane 77 may be electrically connected to an external circuit (e.g., an ASIC chip) for measuring a capacitance. Thus, since it is not required to inject conductive ions into the membrane 77, a separate high temperature heating process is not performed in order to inject metallic ions into the membrane 77.

Even though thermal expansion coefficients of the membrane 77 and the silicon substrate 50 are different, since the membrane 77 and the silicon substrate 50 are not heated at a high temperature, a residual stress such as a compressive stress or a tensile stress is barely generated in a contact region between the membrane 77 and the silicon substrate 50. Thus, the membrane 77 is barely deformed due to a residual stress, thereby preventing the contact region between the membrane 77 and the silicon substrate 50 from cracking.

The membrane 77 may be formed of a flexible conductive material including nickel. Since the membrane 77 is formed of a conductive material, a current may flow through the membrane 77. In addition, the membrane 77 is formed of a flexible material, thereby preventing the membrane 77 from being damaged due to an excessive current or external shocks.

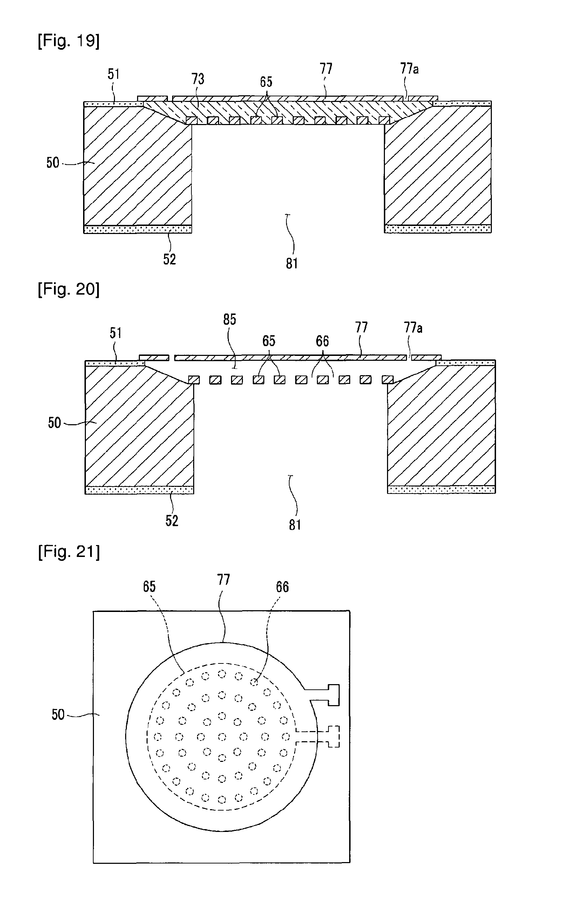

FIGS. 19 and 20 are cross-sectional views for explaining a process of forming a back chamber 81 and an air gap 85 in the silicon substrate 50 of FIG. 18, according to another embodiment of the present invention.

Referring to FIG. 19, a photosensitive mask material (not shown) is coated on the lower insulating protective layer 52 of the silicon substrate 50. A region of the photosensitive mask material, in which the back chamber 81 is to be formed, is patterned by exposing and developing the photosensitive mask material.

The region in which the back chamber 81 is to be formed may be wet-anisotropic etched by a KOH solution or a TMAH solution. In this case, a mask material may be silicon nitride, silicon dioxide, gold, or chrome.

The region in which the back chamber 81 is to be formed may be dry-anisotropic etched by DRIE. In this case, a mask material may be silicon nitride, silicon dioxide, a photosensitive material, gold, or chrome.

The back chamber 81 is formed below the back plate 65 by etching a lower portion of the silicon substrate 50.

Referring to FIG. 20, the sacrificial layer 73 is removed by etching the sacrificial layer 73 through the sound holes 66 of the back plate 65. In this case, the air gap 85 is formed between the membrane 77 and the back plate 65 by removing the sacrificial layer 73. Due to the air gap 85, when a sound pressure acts on the membrane 77, the membrane 77 may vibrate without contacting the back plate 65.

A height of the air gap 85 may be previously determined according to an etching depth of the air-gap forming portion 55 and a depositing height of the sacrificial layer 73. Thus, the membrane 77 and the back plate 65 may be formed in the silicon substrate 50 or a surface of the silicon substrate 50 rather than being formed above the silicon substrate 50. Thus, the height of the MEMS microphone according to the present embodiment may be reduced by as much as the height of the back plate 65 and membrane 77, compared to a conventional MEMS microphone.

Due to an air through hole 77a of the membrane 77, since air may be passed through the air gap 85 and the back chamber 81 when a sound pressure acts on the membrane 77, a pressure that is almost the same as an atmospheric pressure may be formed in the back chamber 81 and the air gap 85. Thus, a sound pressure may normally act on the membrane 77.

FIG. 21 is a top view of the MEMS microphone of FIG. 20 according to another embodiment of the present invention.

Referring to FIG. 21, the air-gap forming portion 55 is formed to have a circular shape on a surface of the silicon substrate 50. The membrane 77 and the back plate 65 may also be formed to have a circular shape on the silicon substrate 50. Of course, the air-gap forming portion 55, the membrane 77, and the back plate 65 may be formed to have a polygonal shape.

The sound holes 66 may be formed in the back plate 65 so that air may pass through the sound holes 66.

Terminals are formed on the membrane 77 and the back plate 65, and thus, the membrane 77 and the back plate 65 may be connected to an external device such as an ASIC chip.

A MEMS microphone according to another embodiment of the present invention will be described below.

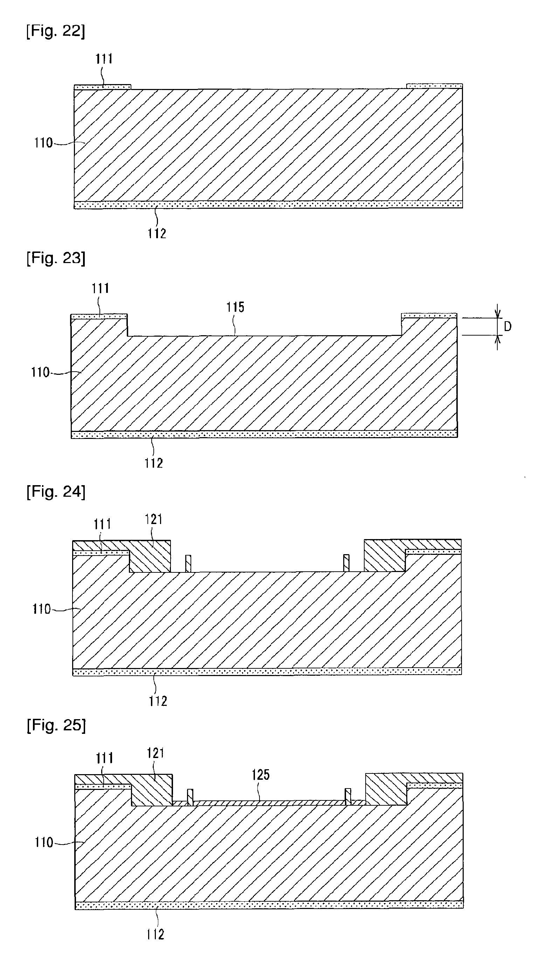

FIGS. 22 and 23 are cross-sectional views for explaining a process of forming an air-gap forming portion 115 on a silicon substrate 110 in a MEMS microphone according to another embodiment of the present invention.

Referring to FIG. 21, the MEMS microphone according to the present embodiment includes the silicon substrate 110. Insulating protective layers 111 and 112 are formed by depositing Si₃N₄ or SiO₂ on two sides of the silicon substrate 110, respectively.

The insulating protective layer 111 formed on an upper surface of the silicon substrate 110 is etched in order to form the air-gap forming portion 115. In this case, the insulating protective layer 111 may be etched by using RIE equipment.

Referring to FIG. 22, a region in which the air-gap forming portion 115 is to be formed may be dry-anisotropic etched by DRIE. In this case, a mask material may be silicon nitride, silicon dioxide, a photosensitive material, gold, or chrome.

By adjusting a depth D of the air-gap forming portion 115, an interval between a membrane 125 and a back plate 137 which will be described below may be adjusted. The depth D of the air-gap forming portion 115 may be adjusted according to etching time and power, a gas partial pressure, an amount of etch gas, or the like.

Two lateral surfaces of the air-gap forming portion 115 may be dry-etched perpendicular to a surface of the silicon substrate 110.

The DRIE dry-etching method is performed based on chemical and physical actions of vapor particles, and thus the two lateral surfaces of the air-gap forming portion 115 are etched perpendicular to the surface of the silicon substrate 110.

FIGS. 24 through 26 are cross-sectional views for explaining a process of forming the membrane 125 on the air-gap forming portion 115 of the silicon substrate 110 of FIG. 23, according to another embodiment of the present invention.

Referring to FIGS. 24 through 26, the membrane 125 is formed on the air-gap forming portion 115 of the silicon substrate 110. An air through hole 125a is formed in the membrane 125. In this case, the membrane 125 is a lower electrode of a condenser for measuring a capacitance, as well as a diaphragm that vibrates according to a sound pressure.

The membrane 125 may be formed by electroless plating. In this case, electroless plating is a method of precipitating metal on a surface of a silicon substrate by reducing metal ions by using an action of a reducing agent without using electrical energy applied from an external source.

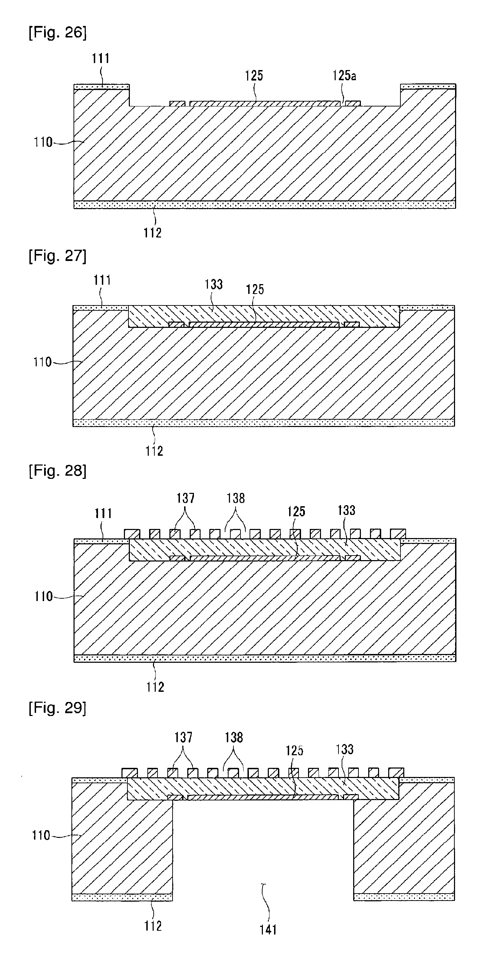

The electroless plating of the membrane 125 is performed as follows. First, a photosensitive mask material 121 is coated on a surface of the silicon substrate 110 on which the air-gap forming portion 115 is formed. A region of a surface of the silicon substrate 110, in which the membrane 125 is to be formed, is patterned by exposing and developing the photosensitive mask material 121 (refer to FIG. 24). The region of the surface of the silicon substrate 110 is activated for nickel electroless plating. The membrane 125 formed of nickel is formed on the activated region of the silicon substrate 110 by electroless plating (refer to FIG. 25). After the membrane 125 formed of nickel is formed, the photosensitive mask material 121 is removed (refer to FIG. 26). Lastly, a surface of the membrane 125 is washed.

In addition, since the membrane 125 is formed by electroless plating in which conductive ions are reduced and substituted at a low temperature of about 90°C, it is not required to heat the membrane 125 at a high temperature of about 1100°C in order to form the membrane 125. Since the membrane 125 is formed of a metallic material, the membrane 125 may be electrically connected to an external circuit (e.g., an ASIC chip) for measuring a capacitance. Thus, a separate high temperature heating process is not performed in order to inject metallic ions into polysilicon, unlike in a conventional method, thereby reducing the number of manufacturing processes.

Since the membrane 125 is heated at a low temperature, a residual stress is barely generated so that the membrane 125 may normally vibrate, thereby stabilizing acoustic feature. In addition, a contact region between the silicon substrate 110 and the membrane 125 may be prevented from cracking.

The membrane 125 may be formed of a flexible conductive material including nickel. Since the membrane 125 is formed of a conductive material, a current may flow through the membrane 125. In addition, since the membrane 125 is formed of a flexible material, the membrane 125 may be prevented from being damaged when the membrane 125 vibrates due to an overvoltage or an external vibration.

The membrane 125 may be formed to have a thickness from about 0.1 to about 5 *µ*m. The thickness of the membrane 125 may be appropriately adjusted according to a sound pressure detected by the MEMS microphone according to the present embodiment.

When the membrane 125 is formed by electroless plating, the membrane 125 may be easily formed on a bent surface, and thus, the membrane 125 and an electrode thereof (not shown) may not short circuit and may be easily connected to each other.

FIGS. 27 and 28 are cross-sectional views for explaining a process of forming a sacrificial layer 133 and a back plate 137 on the membrane 125 of the silicon substrate 112 of FIG. 26, according to another embodiment of the present invention.

Referring to FIG. 27, the sacrificial layer 133 is formed on the air-gap forming portion 115. In this case, since the sacrificial layer 133 is formed on the air-gap forming portion 115 formed by etching the silicon substrate 110 to have the depth D, it is not required to form or etch a separate layer in order to form the sacrificial layer 133. Thus, the sacrificial layer 133 may be easily formed, and the number of manufacturing processes may be reduced.

The sacrificial layer 133 may be formed so that an upper surface of the sacrificial layer 133 may have the same layer level as an upper surface of the silicon substrate 110. In this case, if the sacrificial layer 133 is formed of a material having a relatively high viscosity, a surface of the sacrificial layer 133 may be planarized by CMP. If the sacrificial layer 133 is formed of a material having a relatively low viscosity, the sacrificial layer 133 may be formed to have a planarized surface, and thus, separate CMP may not be performed.

The sacrificial layer 133 may be formed of silicon oxide, photoresist, plating copper, or the like.

Referring to FIG. 28, the back plate 137 may be formed on the sacrificial layer 133 by electroless plating. The back plate 137 may be formed to have a thickness of about 2 to about 100 *µ*m. The back plate 137 is an upper electrode of a condenser, which faces the membrane 125 and measures a capacitance.

Electroless plating of the back plate 137 is performed as follows. First, a photosensitive mask material (not shown) is coated on a surface of the sacrificial layer 133. The photosensitive mask material is exposed and developed, and a region of the photosensitive mask material, in which the back plate 137 is to be formed, is patterned. In this case, the region of the photosensitive mask material, in which the back plate 137 is to be formed, has a predetermined shape so as to have a plurality of sound holes 138. A surface of the back plate 137 is activated for nickel electroless plating. The back plate 137 is formed of nickel on the activated surface of the back plate 137 by electroless plating. After forming the back plate 137 of nickel, the photosensitive mask material. Lastly, the surface of the back plate 137 is washed.

Since the back plate 137 is formed by electroless plating in which conductive ions are reduced and substituted at a low temperature of about 90°C, it is not required to heat the back plate 137 at a high temperature of about 1100°C in order to form the back plate 137. Since the back plate 137 is formed of a metallic material, the back plate 137 may be electrically connected to an external circuit (e.g., an ASIC chip) for measuring a capacitance. Thus, it is not required to perform a separate high temperature heating process in order to inject metallic ions into polysilicon, thereby reducing the number of manufacturing processes.

Even though thermal expansion coefficients of the back plate 137 and the silicon substrate 110 are different, since the back plate 137 and the silicon substrate 110 are not heated at a high temperature, a residual stress such as a compressive stress or a tensile stress is barely generated in a contact region between the back plate 137 and the silicon substrate 110. Thus, the back plate 137 is barely deformed due to a residual stress, thereby stabilizing acoustic feature. In addition, a residual stress is barely generated between the silicon substrate 110 and the back plate 137, thereby preventing the contact region between the silicon substrate 110 and the back plate 137 from cracking.

The back plate 137 may be formed of a flexible conductive material including nickel. Since the back plate 137 is formed of a conductive material, a current may flow through the back plate 137. In addition, since the back plate 137 is formed of a flexible material, the back plate 137 may be prevented from being damaged when external shocks act on the back plate 137.

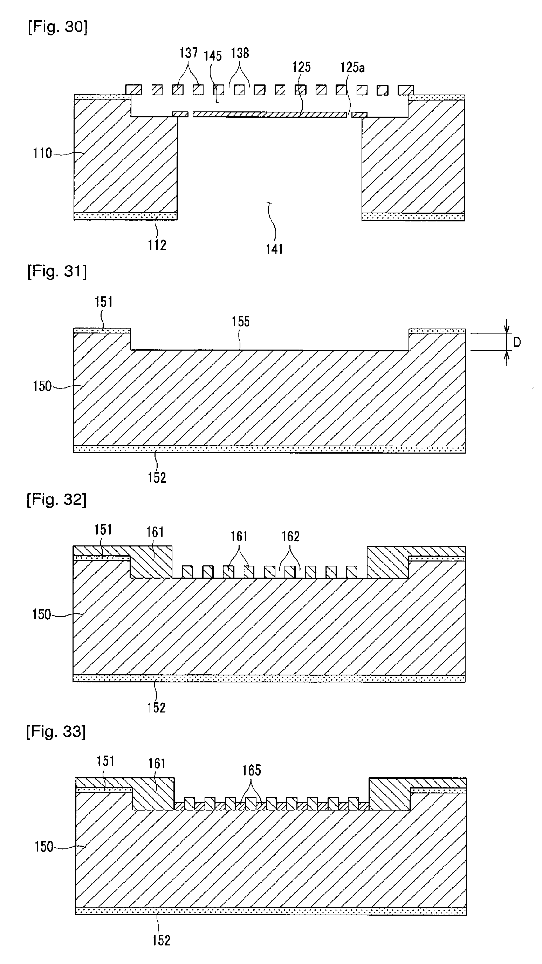

FIGS. 29 and 30 are cross-sectional views for explaining a process of forming a back chamber 141 and an air gap 145 in the silicon substrate 110 of FIG. 28, according to another embodiment of the present invention.

Referring to FIG. 29, a photosensitive mask material (not shown) is coated on the lower insulating protective layer 112 of the silicon substrate 110. A region of the photosensitive mask material, in which the back chamber 141 is to be formed, is patterned by exposing and developing the photosensitive mask material.

The region in which the back chamber 141 is to be formed may be wet-anisotropic etched by a KOH solution or a TMAH solution. In this case, a mask material may be silicon nitride, silicon dioxide, gold, or chrome.

The region in which the back chamber 141 is to be formed may be dry-anisotropic etched by DRIE. In this case, a mask material may be silicon nitride, silicon dioxide, a photosensitive material, gold, or chrome.

The back chamber 141 is formed below the membrane 125 by etching a lower portion of the silicon substrate 110.

Referring to FIG. 30, the sacrificial layer 133 is removed by etching the sacrificial layer 133 through the sound holes 138 of the back plate 137. In this case, the air gap 145 is formed between the membrane 125 and the back plate 137 by removing the sacrificial layer 133. Due to the air gap 145, when a sound pressure acts on the membrane 25, the membrane 125 may vibrate without contacting the back plate 137.

A height of the air gap 145 may be previously determined according to an etching depth of the air-gap forming portion 115 and a depositing height of the sacrificial layer 133. Thus, the height of the MEMS microphone according to the present embodiment may be reduced by as much as the height of the back plate 137 and the membrane 125, compared to a conventional MEMS microphone.

Due to the air through hole 125a of the membrane 125, since air may be passed through the air gap 145 and the back chamber 141 when a sound pressure acts on the membrane 125, a pressure that is almost the same as an atmospheric pressure may be formed in the back chamber 141. Thus, a sound pressure may act normally on the membrane 125.

The air-gap forming portion 115 is formed to have a circular shape, and the membrane 125 and the back plate 137 are also formed to have a circular shape on the silicon substrate 110 (refer to FIG. 5). Of course, the air-gap forming portion 115, the membrane 125, and the back plate 137 may be formed to have a polygonal shape.

Terminals are formed on the membrane 125 and the back plate 137, and thus the membrane 125 and the back plate 137 may be connected to an external device such as an ASIC chip.

A MEMS microphone according to another embodiment of the present invention will be described below.

FIG. 31 is a cross-sectional view for explaining a process of forming an air-gap forming portion 155 on a silicon substrate 150 of a MEMS microphone according to another embodiment of the present invention.

Referring to FIG. 31, the MEMS microphone according to the present embodiment includes the silicon substrate 150. Insulating protective layers 151 and 152 are formed by depositing Si₃N₄ or SiO₂ on two sides of the silicon substrate 150. The insulating protective layer 151 formed on an upper surface of the silicon substrate 150 is etched in order to form the air-gap forming portion 55.

A region in which the air-gap forming portion 155 is to be formed may be dry-anisotropic etched by DRIE. By adjusting a depth D of the air-gap forming portion 155, an interval between the membrane 125 and the back plate 137 which will be described below may be adjusted. The depth D of the air-gap forming portion 155 may be adjusted according to etching time and power, a gas partial pressure, an amount of etch gas, or the like.

Two lateral surfaces of the air-gap forming portion 155 may be dry-etched perpendicular to a surface of the silicon substrate 150. The DRIE dry-etching method is performed based on chemical and physical actions of vapor particles, and thus the two lateral surfaces of the air-gap forming portion 155 are etched perpendicular to the surface of the air-gap forming portion 155.

FIGS. 32 through 34 are cross-sectional views for explaining a process of forming a back plate 165 on the air-gap forming portion 155 of the silicon substrate 150 of FIG. 31, according to another embodiment of the present invention.

Referring to FIGS. 32 through 34, the back plate 165 is formed on the air-gap forming portion 155 of the silicon substrate 150. The back plate 165 may be formed by electroless plating. The back plate 165 is a lower electrode of a condenser for measuring vibration by using a capacitance.

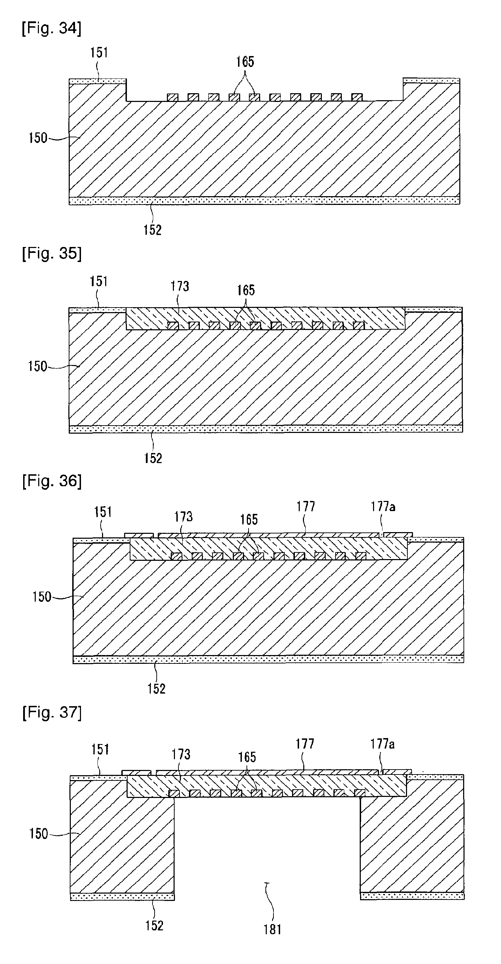

Electroless plating of the back plate 165 is performed as follows. First, a photosensitive mask material 161 is coated on a surface of the silicon substrate 150 on which the air-gap forming portion 155 is formed. A region of the photosensitive mask material 161, in the back plate 165 and a plurality of sound holes 166 are to be formed, is patterned by exposing and developing the photosensitive mask material 161 (refer to FIG. 32). A patterned surface of the silicon substrate 150 is activated for nickel electroless plating. The back plate 165 formed of nickel is formed on the activated surface of the silicon substrate 150 by electroless plating (refer to FIG. 33). After the back plate 165 formed of nickel is formed, the photosensitive mask material 161 is removed (refer to FIG. 34). Lastly, a surface of the back plate 165 is washed.

Since the back plate 165 is formed by electroless plating in which conductive ions are reduced and substituted at a low temperature of about 90°C, it is not required to heat the back plate 165 at a high temperature of about 1100°C in order to form the back plate 165. Since the back plate 165 is formed of a metallic material, the back plate 165 may be electrically connected to an external circuit (e.g., an ASIC chip) for measuring a capacitance. Thus, it is not required to perform a separate high temperature heating process in order to inject or stabilize metallic ions into polysilicon, unlike in a conventional method.

Even though thermal expansion coefficients of the back plate 165 and the silicon substrate 150 are different, since the back plate 165 and the silicon substrate 150 are not heated at a high temperature, a residual stress such as a compressive stress or a tensile stress is barely generated in a contact region between the back plate 165 and the silicon substrate 150. Thus, the back plate 165 is barely deformed due to a residual stress, thereby preventing the contact region between the back plate 165 and the silicon substrate 150 from cracking.

The back plate 165 may be formed of a flexible conductive material including nickel. Since the back plate 165 is formed of a conductive material, a current may flow through the back plate 165. In addition, since the back plate 165 is formed of a flexible material, the back plate 165 may be prevented from being damaged when external shocks act on the back plate 165.

The back plate 165 may be formed to have a thickness of about 2 to about 10 µm. The thickness of the back plate 165 may be appropriately adjusted according to a sound pressure detected by the MEMS microphone according to the present embodiment.

FIGS. 35 and 36 are cross-sectional views for explaining a process of forming a sacrificial layer 173 and a membrane 177 on the silicon substrate 150 of FIG. 34, according to another embodiment of the present invention.

Referring to FIG. 35, the sacrificial layer 173 is formed on the air-gap forming portion 155. In this case, since the sacrificial layer 173 is formed on the air-gap forming portion 155 of the silicon substrate 150, which is etched to have a the depth D, it is not required to form or etch a separate layer in order to form the sacrificial layer 173. Thus, the sacrificial layer 173 may be easily formed, and the number of manufacturing processes may be reduced.

The sacrificial layer 173 may be formed so that an upper surface of the sacrificial layer 173 may have the same layer level as an upper surface of the silicon substrate 150. In this case, if the sacrificial layer 173 is formed of a material having a relatively high viscosity, a surface of the sacrificial layer 173 may be planarized by CMP. If the sacrificial layer 173 is formed of a material having a relatively low viscosity, the sacrificial layer 173may be formed to have a planarized surface, and thus, separate CMP may not be performed.

The sacrificial layer 173 may be formed of silicon oxide, photoresist, plating copper, or the like.

Referring to FIG. 36, the membrane 177 may be formed on the sacrificial layer 173 by electroless plating. An air through hole 177a is formed in the membrane 177. The membrane 177 may be formed to have a thickness of about 0.1 to about 5 *µ*m. The membrane 177 is a diaphragm that faces the back plate 165 and vibrates according to a sound pressure, and constitutes an upper electrode of a condenser for measuring a capacitance, together with the back plate 165.

The electroless plating of the membrane 177 is performed as follows. First, a photosensitive mask material (not shown) is coated on a surface of the sacrificial layer 173. A region of the sacrificial layer 173, in which the membrane 177 is to be formed, is pattern by exposing and developing the photosensitive mask material. The region of a surface of the sacrificial layer 173 is activated for nickel electroless plating. The membrane 177 formed of nickel is formed on the surface of the membrane 77 by electroless plating. After the membrane 177 formed of nickel, the photosensitive material is removed. Lastly, a surface of the membrane 177 is washed.

Since the membrane 177 is formed by electroless plating in which conductive ions are reduced and substituted at a low temperature of about 90°C, it is not required to heat the membrane 177 at a high temperature of about 1100°C in order to form the membrane 177, unlike in a conventional method.

Since the membrane 177 is formed of a metallic material, the membrane 177 may be electrically connected to an external circuit (e.g., an ASIC chip) for measuring a capacitance. Thus, it is not required to perform a separate high temperature heating process in order to inject conductive ions into the membrane 177.

Even though thermal expansion coefficients of the membrane 177 and the silicon substrate 150 are different, since the membrane 177 and the silicon substrate 150 are not heated at a high temperature, a residual stress such as a compressive stress or a tensile stress is barely generated in a contact region between the membrane 177 and the silicon substrate 150. Thus, the membrane 177 is barely deformed due to a residual stress, thereby preventing the contact region between the membrane 177 and the silicon substrate 150 from cracking.

The membrane 177 may be formed of a flexible conductive material including nickel. Since the membrane 177 is formed of a conductive material, a current may flow through the membrane 177. In addition, the membrane 177 is formed of a flexible material, thereby preventing the membrane 177 from being damaged due to an excessive current or external shocks.

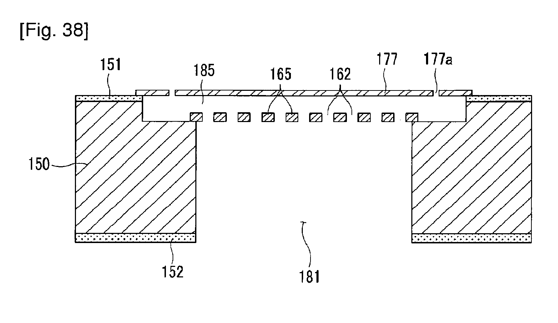

FIGS. 37 and 38 are cross-sectional views for explaining a process of forming a back chamber 181 and an air gap 185 in the silicon substrate 150 of FIG. 36, according to another embodiment of the present invention.

Referring to FIG. 37, a photosensitive mask material (not shown) is coated on the lower insulating protective layer 152 of the silicon substrate 150. A region of the photosensitive mask material, in which the back chamber 181 is to be formed, is patterned by exposing and developing the photosensitive mask material.

The region in which the back chamber 181 is to be formed may be wet-anisotropic etched by a KOH solution or a TMAH solution. In this case, the mask material may be silicon nitride, silicon dioxide, gold, or chrome.

The region in which the back chamber 181 is to be formed may be dry-anisotropic etched by DRIE. In this case, a mask material may be silicon nitride, silicon dioxide, a photosensitive material, gold, or chrome.

The back chamber 181 is formed below the back plate 165 by etching a lower portion of the silicon substrate 150.

Referring to FIG. 38, the sacrificial layer 173 is removed by etching the sacrificial layer 173 through the sound holes 166 of the back plate 165. In this case, the air gap 185 is formed between the membrane 177 and the back plate 165 by removing the sacrificial layer 173. Due to the air gap 185, when a sound pressure acts on the membrane 177, the membrane 177 may vibrate without contacting the back plate 165.

A height of the air gap 185 may be previously determined according to an etching depth of the air-gap forming portion 155 and a depositing height of the sacrificial layer 173. Thus, the membrane 177 and the back plate 165 may be formed in the silicon substrate 150 or a surface of the silicon substrate 150 rather than being formed above the silicon substrate 150. Thus, the height of the MEMS microphone according to the present embodiment may be reduced by as much as the height of the back plate 165 and the membrane 177, compared to a conventional MEMS microphone.

Due to the air through hole 177a of the membrane 177, since air may be passed through the air gap 185 and the back chamber 181 when a sound pressure acts on the membrane 177, a pressure that is almost the same as an atmospheric pressure may be formed in the back chamber 181 and the air gap 185. Thus, a sound pressure may normally act on the membrane 177.

The air-gap forming portion 155, the membrane 177, and the back plate 165 may be formed to have a circular shape or a polygonal shape on the silicon substrate 150.

The sound holes 166 may be formed in the back plate 165 so that air may pass through the sound holes 166. Terminals are formed on the membrane 177 and the back plate 165, and thus, the membrane 177 and the back plate 165 may be connected to an external device such as an ASIC chip.

According to one or more embodiments of the present invention, by adjusting an etch depth of an air-gap forming portion of a MEMS microphone, an air gap between a membrane and a back plate may be adjusted.

Since the membrane and the back plate are formed at a low temperature so that a metallic circuit may be barely deformed, a MEMS chip and an ASIC chip may be manufactured to as a single chip. In addition, the MEMS microphone may be manufactured by using a unified semiconductor manufacturing method.

Since the membrane and the back plate are formed of the same material including nickel, manufacturing processes are simplified and manufacturing costs may be reduced.

Since the back plate and the membrane are formed on a silicon substrate by using the same process, manufacturing processes of the MEMS microphone are simplified, and yield of the MEMS microphone may be remarkably increased.

In addition, the membrane and the back plate are formed at a low temperature by electroless plating, thereby minimizing a residual stress in a contact region between the silicon substrate and the membrane and the back plate. Thus, the membrane may be prevented from being deformed, or the contact region may be prevented from cracking. In addition, manufacturing processes may be simplified, and manufacturing costs may be reduced.

### Industrial Applicability

According to one or more embodiments of the present invention, a residual stress of a membrane and a back plate may be reduced, and a micro electro mechanical systems (MEMS) microphone may be manufactured by using a unified semiconductor manufacturing method, thereby obtaining remarkable industrial applicability.

## Claims

1. A micro electro mechanical systems (MEMS) microphone comprising:
a silicon substrate (10, 50, 110, 150) in which a back chamber (41,81, 141, 181) is formed by etching a lower portion of the silicon substrate, wherein an air-gap forming portion (15, 55, 115, 155) is formed above the chamber by etching an upper portion of the silicon substrate to a predetermined depth above the back chamber;
a membrane (25, 77, 125, 177) formed on the air-gap forming portion (15, 55, 115, 155) of the silicon substrate (10, 50, 110, 150) or the silicon substrate; and
a back plate (37, 65, 137, 165) that is formed on the air-gap forming portion (15, 55, 115, 155) or the silicon substrate (10, 50, 110, 150) so as to be spaced apart from the membrane (25, 77, 125, 177), wherein an air gap (45, 85, 145, 185) is formed between the membrane and the back plate.

2. The MEMS microphone of claim 1, wherein a height of the air gap (45, 85, 145, 185) between the membrane (25, 77, 125, 177) and the back plate (37, 65, 137, 165) is adjusted according to the depth of the air-gap forming portion (15,55, 115, 155).

3. The MEMS microphone of claim 1 or 2, wherein an inclination surface (16, 56) is formed on a circumference of the air-gap forming portion (15, 55,).

4. The MEMS microphone of claim 1, 2 or 3, wherein the membrane (25, 77, 125, 177) and/or the back plate (37, 65, 137, 165) are/is formed by electroless plating.

5. The MEMS microphone of any of the previous claims, wherein at least one of the membrane (25, 77, 125, 177) and the back plate (37, 65, 137, 165) is formed of a flexible conductive material comprising nickel.

6. The MEMS microphone of any of the previous claims, wherein the air-gap forming portion (15, 55, 115, 155) of the silicon substrate (10, 50, 110, 150) is wet-anisotropic etched by a KOH solution or a tetramethylammonium hydroxide (TMAH) solution.

7. The MEMS microphone of any of claims 1 to 5, wherein the air-gap forming portion (15, 55, 115, 155) of the silicon substrate (10, 50, 110, 150) is dry-anisotropic etched by deep reactive ion etching (DRIE).

8. A method of manufacturing a micro electro mechanical systems (MEMS) microphone, the method comprising:
forming an air-gap forming portion (15, 115) having a predetermined depth by etching into an upper portion of a silicon substrate (10, 110);
forming a membrane (25, 125) on the air-gap forming portion of the silicon substrate;
forming a sacrificial layer (33, 133) on the membrane;
forming a back plate (37, 137) on the sacrificial layer so that a plurality of sound holes (38, 138) is formed in the back plate;
forming a back chamber (41, 141) by etching a lower portion of the silicon substrate; and
forming an air gap (45, 145) between the membrane and the back plate by removing the sacrificial layer.

9. A method of manufacturing a micro electro mechanical systems (MEMS) microphone, the method comprising:
forming an air-gap forming portion (55, 155) having a predetermined depth by etching into an upper portion of a silicon substrate (50, 150);
forming a back plate (65, 165) on the air-gap forming portion (55, 155) of the silicon substrate so that a plurality of sound holes (66, 166) is formed in the back plate;
forming a sacrificial layer (73, 173) on the back plate;
forming a membrane (77, 177) on the sacrificial layer;
forming a back chamber (81, 181) by etching a lower portion of the silicon substrate; and
forming an air gap (85, 185) between the membrane and the back plate by removing the sacrificial layer.

10. The method of claim 8 or 9, wherein a height of the air gap (45, 85, 145, 185) between the membrane (25, 77, 125, 177) and the back plate (37, 65, 137, 165) is adjusted according to the depth of the air-gap forming portion (15, 55, 115, 155).

11. The method of claim 10, wherein the forming of the back plate (37, 65, 137, 165) or the forming of the membrane (25, 77, 125, 177) is performed by electroless plating.

12. The method of any of claims 8 to 11, wherein the forming of the back chamber (41,81, 141, 181) is performed by dry-etching with deep reactive ion etching (DRIE), or performed by wet-etching with a KOH solution or a tetramethylammonium hydroxide (TMAH) solution.

13. The method of any of claims 8 to 12, wherein the air-gap forming portion (15, 55, 115, 155) of the silicon substrate (10, 50, 110, 150) is wet-anisotropic etched by a KOH solution or a tetramethylammonium hydroxide (TMAH) solution.

14. The method of any of claims 8 to 13, wherein the air-gap forming portion (15, 55, 115, 155) of the silicon substrate (10, 50, 110, 150) is dry-anisotropic etched by deep reactive ion etching (DRIE).

## Patentansprüche

1. Ein Mikro-elektro-mechanische-Systeme (MEMS)-Mikrofon, das aufweist:
ein Silikon-Substrat (10, 50, 110, 150) in dem eine rückseitige Kammer (41, 81, 141, 181) durch Ätzen eines unteren Bereichs des Silikon-Substrats ausgebildet ist, wobei ein Luftspalt-bildender Bereich (15, 55, 115, 155) oberhalb der Kammer durch Ätzen eines oberen Bereichs des Silikon-Substrats bis zu einer vorgegebenen Tiefe oberhalb der rückseitigen Kammer ausgebildet ist;
eine Membrane (25, 77, 125, 177) ausgebildet auf dem Luftspalt-bildenden Bereich (15, 55, 115, 155) des Silikon-Substrats (10, 50, 110, 150) oder dem Silikon-Substrat; und
eine rückseitige Platte (37, 65, 137, 165), die auf dem Luftspalt-bildenden Bereich (15, 55, 115, 155) oder dem Silikon-Substrat (10, 50, 110, 150) ausgebildet ist, so dass sie von der Membrane (25, 77, 125, 177) beabstandet sind, wobei ein Luftspalt (45, 85, 145, 185) zwischen der Membrane und der rückseitigen Platte ausgebildet ist.

2. Das MEMS-Mikrofon von Anspruch 1, wobei eine Höhe des Luftspalts (45, 85 ,145, 185) zwischen der Membrane (25, 77, 125, 177) und der rückseitigen Platte (37, 65, 137, 165) der Tiefe des Luftspalt-bildenden Bereichs (15, 55, 115, 155) entsprechend eingestellt ist.

3. Das MEMS-Mikrofon von Anspruch 1 oder 2, wobei eine Neigungsfläche (16, 56) an einem Umfang des Luftspalt-bildenden Bereichs (15, 55) ausgebildet ist.

4. Das MEMS-Mikrofon von Anspruch 1, 2 oder 3, wobei die Membrane (25, 77, 125, 177) und/oder die rückseitige Platte (37, 65, 137, 165) durch stromlose Beschichtung ausgebildet sind/ist.

5. Das MEMS-Mikrofon von irgendeinem der vorangehenden Ansprüche, wobei von der Membrane (25, 77, 125, 177) und der rückseitigen Platte (37, 65, 137, 165) zumindest eine aus einem flexiblen leitenden Material, das Nickel aufweist, ausgebildet ist.

6. Das MEMS-Mikrofon von irgendeinem der vorangehenden Ansprüche, wobei das Luftspalt-bildende Bereich (15, 55, 115, 155) des Silikon-Substrats (10, 50, 110, 150) durch eine KOH-Lösung oder eine Tetramethylammonium-Hydroxid (TMAH)-Lösung nass-anisotrop geätzt ist.

7. Das MEMS-Mikrofon von irgendeinem der Ansprüche 1 bis 5, wobei das Luftspalt-bildende Bereich (15, 55, 115, 155) des Silikon-Substrats (10, 50, 110, 150) durch Reaktives Ionentiefenätzen (DRIE) trocken-anisotrop geätzt ist.

8. Ein Verfahren zur Herstellung eines Mikro-elektro-mechanische-Systeme (MEMS)-Mikrofons, wobei das Verfahren aufweist:
Ausbilden eines Luftspalt-bildenden Bereichs (15, 115), der durch Ätzen in einen oberen Bereich eines Silikon-Substrats (10, 110) eine vorgegebene Tiefe hat;
Ausbilden einer Membrane (25, 125) auf dem Luftspalt-bildenden Bereich des Silikon-Substrats;
Ausbilden einer Opferschicht (33, 133) auf der Membrane;
Ausbilden einer rückseitigen Platte (37, 137) auf der Opferschicht in der Weise, dass eine Vielzahl von Schalllöchern (38, 138) in der rückseitigen Platte ausgebildet wird;
Ausbilden einer rückseitigen Kammer (41, 141) durch Ätzen eines unteren Bereichs des Silikon-Substrats; und
Ausbilden eines Luftspalts (45, 145) zwischen der Membrane und der rückseitigen Platte durch Entfernen der Opferschicht.

9. Ein Verfahren zur Herstellung eines Mikro-elektro-mechanische-Systeme (MEMS)-Mikrofons, wobei das Verfahren aufweist:
Ausbilden eines Luftspalt-bildenden Bereichs (55, 155), der durch Ätzen in einen oberen Bereich eines Silikon-Substrats (50, 150) eine vorgegebene Tiefe hat;
Ausbilden einer rückseitigen Platte (65, 165) auf dem Luftspalt-bildenden Bereich (55, 155) des Silikon-Substrats in der Weise, dass eine Vielzahl von Schalllöchern (66, 166) in der rückseitigen Platte ausgebildet wird;
Ausbilden einer Opferschicht (73, 173) auf der rückseitigen Platte;
Ausbilden einer Membrane (77, 177) auf der Opferschicht;
Ausbilden einer rückseitigen Kammer (81, 181) durch Ätzen eines unteren Bereichs des Silikon-Substrats; und
Ausbilden eines Luftspalts (85, 185) zwischen der Membrane und der rückseitigen Platte durch Entfernen der Opferschicht.

10. Das Verfahren von Anspruch 8 oder 9, wobei eine Höhe des Luftspalts (45, 85, 145 185) zwischen der Membrane (25, 77, 125, 177) und der rückseitigen Platte (37, 65, 137, 165) der Tiefe des Luftspalt-bildenden Bereichs (15, 55, 115, 155) entsprechend eingestellt ist.

11. Das Verfahren von Anspruch 10, wobei das Ausbilden der rückseitigen Platte (37, 65, 137, 165) oder das Ausbilden der Membranen (25, 77, 125, 177) durch stromlose Beschichtung durchgeführt wird.

12. Das Verfahren von irgendeinem der Ansprüche 8 bis 11, wobei das Ausbilden der rückseitigen Kammer (41, 81, 141, 181) durch Trocken-Ätzen mit Reaktivem Ionentiefenätzen (DRIE) durchgeführt wird, oder durch Nass-Ätzen mit einer KOH-Lösung oder einer Tetramethylammonium-Hydroxid (TMAH)-Lösung durchgeführt wird.

13. Das Verfahren von irgendeinem der Ansprüche 8 bis 12, wobei der Luftspalt-bildende Bereich (15, 55, 115, 155) des Silikon-Substrats (10, 50, 110, 150) durch eine KOH-Lösung oder eine Tetramethylammonium-Hydroxid (TMAH)-Lösung nass-anisotrop geätzt wird.

14. Das Verfahren von irgendeinem der Ansprüche 8 bis 13, wobei der Luftspalt-bildende Bereich (15, 55, 115, 155) des Silikon-Substrats (10, 50, 110, 150) durch Reaktives Ionentiefenätzen (DRIE) trocken-anisotrop geätzt wird.

## Revendications

1. Microphone à microsystème électromécanique (MEMS) comprenant :
un substrat de silicium (10, 50, 110, 150) dans lequel une chambre arrière (41, 81, 141, 181) est formée en gravant une partie inférieure du substrat de silicium, une partie (15, 55, 115, 155) formant un espace d'air étant formée au-dessus de la chambre en gravant une partie supérieure du substrat de silicium sur une profondeur prédéterminée au-dessus de la chambre ;
une membrane (25, 77, 125, 177) formée sur la partie (15, 55, 115, 155) formant un espace d'air du substrat de silicium (10, 50, 110, 150) ou le substrat de silicium ; et
une plaque arrière (37, 65, 137, 165) qui est formée sur la partie (15, 55, 115, 155) formant un espace d'air ou le substrat de silicium (10, 50, 110, 150) de façon à être espacée de la membrane (25, 77, 125, 177), l'espace d'air (45, 85, 145, 185) étant formé entre la membrane et la plaque arrière.

2. Microphone MEMS selon la revendication 1, dans lequel une hauteur de l'espace d'air (45, 85, 145, 185) entre la membrane (25, 77, 125, 177) et la plaque arrière (37, 65, 137, 165) est réglée en fonction de la profondeur de la partie (15, 55, 115, 155) formant un espace d'air.

3. Microphone MEMS selon l'une des revendications 1 ou 2, dans lequel une surface inclinée (16, 56) est formée sur une circonférence de la partie (15, 55) formant un espace d'air.

4. Microphone MEMS selon l'une des revendications 1, 2 ou 3, dans lequel la membrane (25, 77, 125, 177) et/ou la plaque arrière (37, 65, 137, 165) est/sont formée(s) par dépôt autocatalytique.

5. Microphone MEMS selon l'une quelconque des revendications précédentes, dans lequel la membrane (25, 77, 125, 177) et/ou la plaque arrière (37, 65, 137, 165) est/sont formée(s) d'un matériau conducteur flexible comprenant du nickel.

6. Microphone MEMS selon l'une quelconque des revendications précédentes, dans lequel la partie (15, 55, 115, 155) formant un espace d'air du substrat de silicium (10, 50, 110, 150) est gravée par voie humide anisotrope par une solution de KOH ou une solution d'hydroxyde de tétraméthylammonium (TMAH).

7. Microphone MEMS selon l'une quelconque des revendications 1 à 5, dans lequel la partie (15, 55, 115, 155) formant un espace d'air du substrat de silicium (10, 50, 110, 150) est gravée par voie sèche anisotrope par gravure ionique réactive profonde (DRIE).

8. Procédé de fabrication d'un microphone à microsystème électromécanique (MEMS), lequel procédé consiste à :
former une partie (15, 115) formant un espace d'air ayant une profondeur prédéterminée par gravure dans une partie supérieure d'un substrat de silicium (10, 110) ;
former une membrane (25, 125) sur la partie formant un espace d'air du substrat de silicium ;
former une couche sacrificielle (33, 133) sur la membrane ;
former une plaque arrière (37, 137) sur la couche sacrificielle de façon à former une pluralité de trous acoustiques (38, 138) dans la plaque arrière;
former une chambre arrière (41, 141) en gravant une partie inférieure du substrat de silicium ; et
former un espace d'air (45, 145) entre la membrane et la plaque arrière en retirant la couche sacrificielle.

9. Procédé de fabrication d'un microphone à microsystème électromécanique (MEMS), lequel procédé consiste à :
former une partie (55, 155) formant un espace d'air ayant une profondeur prédéterminée par gravure dans une partie supérieure d'un substrat de silicium (50, 150) ;
former une plaque arrière (65, 165) sur la partie (55, 155) formant un espace d'air du substrat de silicium de façon à former une pluralité de trous acoustiques (66, 166) dans la plaque arrière;
former une couche sacrificielle (73, 173) sur la plaque arrière ;
former une membrane (77, 177) sur la couche sacrificielle ;
former une chambre arrière (81, 181) en gravant une partie inférieure du substrat de silicium ; et
former un espace d'air (85, 185) entre la membrane et la plaque arrière en retirant la couche sacrificielle.

10. Procédé selon l'une des revendications 8 ou 9, selon lequel une hauteur de l'espace d'air (45, 85, 145, 185) entre la membrane (25, 77, 125, 177) et la plaque arrière (37, 65, 137, 165) est réglée en fonction de la profondeur de la partie (15, 55, 115, 155) formant un espace d'air.

11. Procédé selon la revendication 10, selon lequel la formation de la plaque arrière (37, 65, 137, 165) ou la formation de la membrane (25, 77, 125, 177) est réalisée par dépôt autocatalytique.

12. Procédé selon l'une quelconque des revendications 8 à 11, selon lequel la formation de la chambre arrière (41, 81, 141, 181) est réalisée par gravure sèche au moyen d'une gravure ionique réactive profonde (DRIE) ou réalisée par gravure humide avec une solution de KOH ou une solution d'hydroxyde de tétraméthylammonium (TMAH).

13. Procédé selon l'une quelconque des revendications 8 à 12, selon lequel la partie (15, 55, 115, 155) formant un espace d'air du substrat de silicium (10, 50, 110, 150) est gravée par voie humide anisotrope par une solution de KOH ou une solution d'hydroxyde de tétraméthylammonium (TMAH).

14. Procédé selon l'une quelconque des revendications 8 à 13, selon lequel la partie (15, 55, 115, 155) formant un espace d'air du substrat de silicium (10, 50, 110, 150) est gravée par voie sèche anisotrope par gravure ionique réactive profonde (DRIE).
